# EUROPÄISCHE PATENTSCHRIFT

(11) **EP 3 341 961 B1**
(45) Veröffentlichungstag und Bekanntmachung des Hinweises auf die Patenterteilung: **14.07.2021**
(21) Anmeldenummer: 16753706.7
(22) Anmeldetag: 02.08.2016
(51) Int. Cl.: H01L 21/687, C23C 16/458, C23C 16/46, H01L 21/67, C23C 14/50, C23C 14/54, C23C 14/56, C23C 16/54

(54) **SUBSTRATBEHANDLUNGSVORRICHTUNG**
SUBSTRATE TREATMENT DEVICE
DISPOSITIF DE TRAITEMENT DE SUBSTRAT

(30) Priorität: 24.08.2015 DE 102015113962
(43) Veröffentlichungstag der Anmeldung: 04.07.2018
(73) Patentinhaber: Meyer Burger (Germany) GmbH, 09337 Hohenstein-Ernstthal (DE)
(72) Erfinder: RASCHKE, Sebastian, 09380 Thalheim (DE); ANSORGE, Erik, 09127 Chemnitz (DE); KEHR, Mirko, 09439 Amtsberg (DE); BÖHM, Christian, 09337 Hohenstein-Ernstthal (DE)
(74) Vertreter: Steiniger, Carmen
(86) Internationale Anmeldenummer: PCT/IB2016/054632
(87) Internationale Veröffentlichungsnummer: WO 2017/033077

(56) Entgegenhaltungen:
- EP-A1- 1 365 040
- EP-A1- 2 518 763
- DE-A1-102012 100 927
- US-A- 5 580 388
- US-A1- 2007 157 886

## Beschreibung

Die vorliegende Erfindung betrifft eine Substratbehandlungsvorrichtung zur Behandlung von Substraten mit einem plattenförmigen Substratträger und wenigstens einer plattenförmigen, parallel zu dem Substratträger angeordneten Temperiervorrichtung, wobei der Substratträger eine Substratträgervorderseite zur Auflage wenigstens eines flächigen Substrates und eine der Temperiervorrichtung zugewandte Substratträgerrückseite aufweist.

Eine derartige Substratbehandlungsvorrichtung ist beispielsweise aus der Druckschrift DE 10 2010 000 001 A1 bekannt. In dieser wird auf einem plattenförmigen Substratträger ein flächiges Halbleitersubstrat, wie beispielsweise ein Siliziumwafer, durch eine Bearbeitungskammer bewegt, um beispielsweise eine Passivierungsschicht auf dem Halbleitersubstrat abzuscheiden. Das Halbleitersubstrat befindet sich dafür auf einer Vorderseite des Substratträgers, während der Rückseite des Substratträgers zugewandt wenigstens eine plattenförmige Heiz- und/oder Kühlvorrichtung angeordnet ist.

Bei derartigen Substratbehandlungsvorrichtungen liegt üblicherweise ein direkter, flächiger Kontakt zwischen dem Substratträger und der Heiz- und/oder Kühlvorrichtung vor, welche beispielsweise eine Heizplatte sein kann. Dieser flächige Kontakt ist jedoch in der Realität nie ideal ganzflächig, sondern es ergibt sich durch Unregelmäßigkeiten in den Oberflächen des Substratträgers und der Heizplatte in der Realität eine meist nicht exakt bestimmbare, stellenweise Auflage anstatt einer flächigen. Daher konzentriert sich häufig die Erwärmung des Substratträgers und damit des darauf aufliegenden Substrates im Falle einer Heizvorrichtung auf einzelne Stellen. Dies führt zu einer inhomogenen, ungleichmäßigen Wärmeverteilung im Substratträger, wodurch sich Verwerfungen und Spannungen im Substratträger bilden können, sodass dieser sich verformen kann. Außerdem führt die ungleichmäßige Wärmeverteilung im Substratträger auch zu einer ungleichmäßigen Temperierung des wenigstens einen auf der Substratträgervorderseite vorgesehenen Substrates.

In der Druckschrift EP 1 365 040 A1 ist eine Substratträgervorrichtung beschrieben, welche einen Substratträger aufweist, in welchem Heizelemente direkt integriert sind.

Die Druckschrift US 5,580,388 A offenbart eine Substratträgervorrichtung, welche einen aus zwei Schichten ausgebildeten, plattenförmigen Substratträger aufweist, unterhalb welchem eine als Temperiervorrichtung fungierende Trägerplatte vorgesehen ist. Die Trägerplatte ist durch Distanzelemente von dem Substratträger beabstandet.

Die Druckschrift US 2007 / 157 886 A1 beinhaltet eine Substratbehandlungsvorrichtung, welche eine Substratträgervorrichtung mit Substratträger aufweist. Der plattenförmige Substratträger ist durch Distanzelemente beabstandet über einer Wärmeregulierungsplatte angeordnet. Die Wärmeregulierungsplatte ist wiederum durch Abstandselemente von einem Hauptstellglied, welches zugleich als Wärmeplatte fungiert, beabstandet oberhalb des Hauptstellgliedes angebracht.

In der Druckschrift DE 10 2012 100 927 A1 ist ein Prozessmodul mit einer in dem Prozessmodul befindlichen Prozesskammer und einer horizontal durch das Prozessmodul bewegbaren Trägervorrichtung beschrieben. Die Trägervorrichtung dient zum einen einem Transport eines Substrates zu der Prozesskammer und zum anderen ist die Prozesskammer durch die Trägervorrichtung körperlich abschließbar. Hierzu wird die Trägervorrichtung in eine Schließrichtung, quer zu einer Substrattransportrichtung bewegt. Unterhalb der Trägervorrichtung ist eine Temperiervorrichtung vorgesehen, welche durch Distanzelemente von der Trägervorrichtung beabstandet ist.

Es ist die Aufgabe der vorliegenden Erfindung, eine Substratbehandlungsvorrichtung vorzuschlagen, die eine möglichst gleichmäßige Wärmeverteilung im Substratträger ermöglicht.

Die Aufgabe wird erfindungsgemäß dadurch gelöst, dass an der Substratträgerrückseite und/oder auf einer dem Substratträger zugewandten Oberfläche der Temperiervorrichtung wenigstens ein Distanzelement zur Ausbildung eines Abstandes zwischen dem Substratträger und der Temperiervorrichtung vorgesehen ist.

Erfindungsgemäß ist also zwischen dem Substratträger und der Temperiervorrichtung wenigstens ein Distanzelement, also ein Abstandshalter, angeordnet, wodurch eine direkte Berührung zwischen dem Substratträger und der Temperiervorrichtung vermieden wird. Damit werden punktuelle heiße Stellen durch Schockaufheizung, sogenannte Hotspots, im Substratträger vermieden. Inhomogenitäten eines Abstandes zwischen dem Substratträger und der Temperiervorrichtung, die beispielsweise durch Bearbeitungstoleranzen hervorgerufen sein können, können mithilfe des wenigstens einen Distanzelementes ausgeglichen werden. Es kann beispielsweise ein Raster von mehreren Distanzelementen vorgesehen sein, welches Inhomogenitäten genau an den Positionen ausgleicht, an denen sie auftreten. Dadurch wird zwischen dem Substratträger und der Temperiervorrichtung ein möglichst homogener, gleichmäßiger Abstand bereitgestellt. Weiterhin ist eine Summe aus einer Bearbeitungstoleranz in Dickenrichtung des Substratträgers, einer Dickentoleranz des wenigstens einen Distanzelementes und einer Montagetoleranz des wenigstens einen Distanzelementes an den Substratträger und/oder der Temperiervorrichtung in Dickenrichtung des Substratträgers bezogen auf eine Dicke des Distanzelementes verhältnismäßig gering. Vorzugsweise beträgt diese Summe weniger als 10 %, besonders bevorzugt weniger als 5 % der Dicke des Distanzelementes. Somit wird ein Aufheizverhalten des Substratträgers im Gegensatz zum Stand der Technik nicht mehr wesentlich durch die genannten lokalen Toleranzen des Substratträgers und des Distanzelementes beeinflusst, sondern das Aufheizverhalten ist durch die Dicke des wenigstens einen Distanzelementes gezielt einstellbar.

Eine Wärmeübertragung zwischen der Temperiervorrichtung und dem Substratträger kann somit je nach umgebendem Medium im Wesentlichen durch Konvektion oder Wärmestrahlung erfolgen, zu einem gewissen Anteil auch durch Wärmeleitung durch das wenigstens eine Distanzelement. Dies garantiert einen gleichmäßigen Wärmeeintrag in den Substratträger, wodurch eine homogene Wärmeverteilung im Substratträger erreicht werden kann. Somit können Verwerfungen des Substratträgers und eine ungleichmäßige Temperierung der auf dem Substratträger befindlichen Substrate vermieden werden.

Weiterhin wird die Wärmeübertragung zwischen dem Substratträger und der Temperiervorrichtung gedrosselt. Im Falle eines Heizvorgangs kommt es also zu einem verzögerten Aufheizen des Substratträgers, insbesondere bei dem Ablegen eines Substratträgers auf einer Heizplatte wird ein Thermoschock durch die Distanzelemente vermieden.

Das erfindungsgemäße Distanzelement kann verschiedene Geometrien aufweisen. Beispielsweise kann das Distanzelement in einem Querschnitt als Kreis, Kreisring, Vieleck oder ein innen hohles Vieleck ausgebildet sein. Weiterhin kann das Distanzelement Ausnehmungen und/oder Durchbrechungen aufweisen, sodass das Distanzelement an möglichst wenigen Stellen zwischen dem Substratträger und der Temperiervorrichtung vorliegt und die Wärmeübertragung zwischen der Temperiervorrichtung und dem Substratträger nicht mehr als nötig beeinflusst. Vorteilhafterweise weist das wenigstens eine Distanzelement in einer zur Substratträgerrückseite parallelen Erstreckungsrichtung eine Breite und/oder Länge von 1 mm bis 50 mm, bevorzugt von 5 mm bis 35 mm, besonders bevorzugt von 15 mm bis 25 mm, auf. Die Breite und/oder Länge bezieht sich dabei auf einen durchgehenden Bereich des Distanzelementes, kann also insbesondere durch Unterbrechungen des Distanzelementes oder durch gekrümmte Kanten begrenzt sein.

Das wenigstens eine Distanzelement kann sowohl auf der Substratträgerrückseite als auch auf der dem Substratträger zugewandten Seite der Temperiervorrichtung angeordnet sein. Das wenigstens eine Distanzelement kann beispielsweise in die Oberfläche der Substratträgerrückseite und/oder in die Oberfläche der dem Substratträger zugewandten Seite der Temperiervorrichtung eingearbeitet sein, also in Form einer einstückigen Ausbildung. Alternativ kann das wenigstens eine Distanzelement auch an die Substratträgerrückseite und/oder die dem Substratträger zugewandte Seite der Temperiervorrichtung angeschraubt oder andersartig fest mit einer der genannten Oberflächen verbunden sein. Vorteilhaft ist es, die Verbindung zwischen Substratträger und Distanzelement(en) lösbar zu gestalten, wodurch das wenigstens eine Distanzelement austauschbar ist. Es ist auch eine Ausführungsform möglich, in der das wenigstens Distanzelement auf der Substratträgerrückseite und/oder auf der Oberfläche der dem Substratträger zugewandten Seite der Temperiervorrichtung frei beweglich aufgelegt ist. Beispielsweise kann/können auf die Temperiervorrichtung eine oder mehrere Distanzmatten als Distanzelement(e) aufgelegt sein.

In einer besonders bevorzugten Ausführungsform der erfindungsgemäßen Substratbehandlungsvorrichtung ist eine Vielzahl der Distanzelemente zur Ausbildung des Abstandes zwischen dem Substratträger und der Temperiervorrichtung vorgesehen. Somit können viele kleine Distanzelemente zwischen dem Substratträger und der Temperiervorrichtung vorliegen, wodurch der Abstand zwischen dem Substratträger und der Temperiervorrichtung insbesondere auch in einem Außenbereich des Substratträgers genau so groß gehalten werden kann wie in einem mittigen Bereich des Substratträgers. Vorzugsweise ist dabei die Höhe der Distanzelemente, mit der diese von der Substratträgerrückseite und/oder von der dem Substratträger zugewandten Seite der Temperiervorrichtung herausragen, gleich groß, kann jedoch auch zum Ausgleich von Inhomogenitäten unterschiedlich groß sein. Durch die Verwendung einer Vielzahl von Distanzelementen kann eine thermische Ankopplung des Substratträgers an die Temperiervorrichtung besonders gleichmäßig gestaltet werden.

In einer vorteilhaften Variante der erfindungsgemäßen Substratbehandlungsvorrichtung ist vorgesehen, dass das Material des wenigstens einen Distanzelementes eine geringere Wärmeleitfähigkeit als das Material des Substratträgers aufweist. Somit kann die Wärmeübertragung zwischen der Temperiervorrichtung und dem Substratträger über das wenigstens eine Distanzelement gering gehalten und damit eine punktuelle Erwärmung von dem Substratträger und/oder dem Substrat weitgehend verhindert werden. Die Erwärmung des Substratträgers erfolgt in diesem Fall dann, wenn die Behandlung des Substrates beispielsweise unter einer Gasatmosphäre erfolgt, im Wesentlichen über ein zwischen der Temperiervorrichtung und dem Substratträger vorhandenes Gaspolster. Dadurch kann die Wärmeübertragung zwischen Temperiervorrichtung und Substratträger durch Konvektion erfolgen, welche zu einer gleichmäßigen Wärmeverteilung führt.

Das Distanzelement kann beispielsweise aus wenigstens einem elektrisch isolierenden Material ausgebildet und/oder mit wenigstens einem elektrisch isolierenden Material beschichtet sein. Elektrisch isolierende Materialien sind zumeist durch eine niedrige Wärmeleitfähigkeit gekennzeichnet. Als Material für das Distanzelement kommt in diesem Fall beispielsweise Keramik, Glas und/oder ein Kunststoff in Betracht, etwa Polyetheretherketon, Teflon, ein Polyimid und/oder Silikon. Grundsätzlich ist es jedoch bei der vorliegenden Erfindung auch möglich, das wenigstens eine Distanzelement wenigstens teilweise aus Aluminium, einem anderen metallischen Werkstoff oder Carbon auszubilden.

Das Distanzelement kann vorteilhafterweise als Geflecht oder schwammartig ausgeformt sein, um eine geringe Wärmeleitung zwischen der Temperiervorrichtung und dem Substratträger zu realisieren. Alternativ kann das Distanzelement oder Teile davon als Netz, Matrix und/oder eine Matte ausgebildet sein. Das Distanzelement kann ganzflächig oder Teilbereiche zwischen der Temperiervorrichtung und dem Substratträger abdeckend ausgeführt sein. Beispielsweise ist die Verwendung einer Glaswolle- oder Silikonmatte als Distanzelement möglich. Derartige Matten sind üblicherweise nachgiebig und/oder komprimierbar, Inhomogenitäten in dem Abstand zwischen dem Substratträger und der Temperiervorrichtung können also ganzflächig durch eine Komprimierbarkeit des Distanzelementes ausgeglichen werden.

Gemäß einer bevorzugten Weiterbildung der erfindungsgemäßen Substratbehandlungsvorrichtung kragt das wenigstens eine Distanzelement aus dem Substratträger und/oder aus der Temperiervorrichtung um eine Höhe von 0,1 mm bis 1 mm, besonders bevorzugt um eine Höhe von 0,2 mm bis 0,5 mm, insbesondere von 0,3 mm bis 0,4 mm, aus. Somit wird ein ausreichender und dennoch geringer Abstand zwischen der Temperiervorrichtung und dem Substratträger ausgebildet, sodass die Wärmeübertragung im Falle von Konvektion in einer Gasatmosphäre effektiv und gleichmäßig erfolgt. Gleichzeitig führt dieser Abstand beispielsweise in einem Vakuum zu einem Halten der Temperatur des Substratträgers zwischen verschiedenen Temperiervorrichtungen, da ein Wärmeverlust durch Wärmeleitung minimiert ist und durch Wärmestrahlung nur ein geringer Wärmeverlust auftreten kann.

In einer vorteilhaften Ausführungsform der erfindungsgemäßen Substratbehandlungsvorrichtung weist das wenigstens eine Distanzelement eine veränderbare Höhe auf. Das Distanzelement kann also beispielsweise teleskopartig ein- und ausfahrbar ausgebildet sein. Weiterhin kann das Distanzelement aus der Temperiervorrichtung und/oder aus der Substratträgerrückseite ausfahrbar und/oder höhenverstellbar ausgebildet und/oder befestigt sein. Beispielsweise kann die Temperiervorrichtung wenigstens ein Loch oder eine Bohrung aufweisen, aus dem/der das Distanzelement ausgefahren und in dem/der das Distanzelement versenkt werden kann. Damit ist es möglich, den Substratträger zunächst durch das wenigstens eine Distanzelement weit beabstandet zu der Temperiervorrichtung aufzulegen, also beispielsweise mit einem Abstand von 1 mm, wodurch zunächst eine gedrosselte Temperierung des Substratträgers erfolgt. Anschließend kann das wenigstens eine Distanzelement in seiner Höhe verringert werden, beispielsweise auf etwa 0,3 mm, wodurch die Wärmeübertragung zwischen der Temperiervorrichtung und dem Substratträger daraufhin aufgrund des geringeren Abstandes effektiver erfolgt. Somit wird zunächst eine Schocktemperierung vermieden und anschließend eine effektive Wärmeübertragung gewährleistet.

Vorteilhaft ist es weiterhin, wenn der Substratträger aus wenigstens einem elektrisch leitfähigen Material ausgebildet und/oder mit wenigstens einem elektrisch leitfähigen Material beschichtet ist. Durch die zumeist gute Wärmeleitfähigkeit von elektrisch leitfähigem Material kann hierdurch die Temperatur der Temperiervorrichtung vorteilhaft auf den Substratträger übertragen werden. Weiterhin begünstigt die elektrische Leitfähigkeit des Substratträgers eine homogene Wärmeverteilung innerhalb des Substratträgers, wodurch sich eventuell entstehende Hotspots innerhalb des Substratträgers thermisch ausgleichen können und dadurch Spannungen und Verformungen des Substratträgers vermieden werden.

Außerdem kann der Substratträger bei der Ausgestaltung als elektrischer Leiter in der Substratbehandlungsvorrichtung beispielsweise als eine Elektrode genutzt werden. Dies ist insbesondere von Vorteil, wenn das wenigstens eine zu behandelnde Substrat auf ein bestimmtes elektrisches Potenzial eingestellt werden soll. Als Material kommt beispielsweise ein Metall oder eine Legierung in Betracht, insbesondere Aluminium, Titan oder eine Legierung dieser Metalle.

Es bietet sich an, die Dicke des Substratträgers zwischen der Substratträgervorderseite und der Substratträgerrückseite so hoch wie möglich zu wählen, um die Wahrscheinlichkeit eines Aufbeulens des Substratträgers aufgrund von Temperaturinhomogenitäten zu vermeiden. Einerseits wird so die Steifigkeit des Substratträgers vergrößert, wodurch der Substratträger thermisch induzierten Spannungen besser widerstehen kann als mit einer geringeren Dicke. Andererseits wird dadurch die Wärmeverteilung in dem Substratträger verbessert und beschleunigt, was einem Aufbeulen des Substratträgers ebenfalls entgegenwirkt. Die Dicke des Substratträgers sollte jedoch eine Maximaldicke nicht überschreiten, da sich eine zunehmende Dicke des Substratträgers nachteilig auf eine Dynamik eines Aufheiz- und/oder Abkühlvorgangs an dem Substratträger auswirkt, da sich mit einer zunehmenden Dicke auch die thermische Masse des Substratträgers erhöht. Durch den Einsatz wenigstens eines Distanzelementes zwischen dem Substratträger und der Temperiervorrichtung können Temperaturinhomogenitäten und dadurch induzierte mechanische Spannungen reduziert werden und die Dicke und damit die Masse und die thermische Masse des Substratträgers auf einem Minimum gehalten werden. Die Dicke des Substratträgers steht also in Wechselwirkung mit der Höhe des Distanzelementes; je höher das Distanzelement ist, desto kleiner kann die Dicke des Substratträgers bemessen sein. Die minimierte Masse des Substratträgers ermöglicht es weiterhin, einen möglichen Transportmechanismus zum Transport des Substratträgers gering dimensioniert auszuführen.

Es hat sich als vorteilhaft herausgestellt, wenn der Substratträger zwischen der Substratträgervorderseite und der Substratträgerrückseite eine Dicke von 8 mm bis 21 mm, bevorzugt von 10 mm bis 15 mm, besonders bevorzugt von 11 mm bis 13 mm, aufweist. Für eine Breite des Substratträgers zwischen 120 cm bis 200 cm ergibt sich also ein Aspektverhältnis aus der Dicke und der Breite des Substratträgers von etwa 0,4 % bis 1,8 %. Für Substratträger anderer Längen und Breiten können sich andere vorteilhafte Dicken des Substratträgers ergeben.

In einer besonders bevorzugten Ausführungsform der erfindungsgemäßen Substratbehandlungsvorrichtung weist die Substratträgerrückseite eine Oberflächenmodifizierung und/oder eine Oberflächenbeschichtung auf, wobei die Oberflächenmodifizierung und/oder die Oberflächenbeschichtung mehr Wärmestrahlung absorbiert als ein Grundmaterial des Substratträgers. Dies ist insbesondere vorteilhaft, wenn die Wärmeübertragung zwischen der Temperiervorrichtung und dem Substratträger im Wesentlichen durch Wärmestrahlung erfolgt. Besteht der Substratträger oder dessen Oberfläche aus einem Metall, beispielsweise Aluminium, oder einer Metalllegierung, so wird ein Großteil der Wärmestrahlung reflektiert und eine effektive Wärmeübertragung zwischen der Temperiervorrichtung und dem Substratträger findet nicht statt. Wird auf der Substratträgerrückseite jedoch die Oberfläche derart funktionalisiert, dass Wärmestrahlung gut absorbiert werden kann, ist eine effektive Wärmeübertragung durch Wärmestrahlung möglich, was insbesondere für Prozesse im Vakuum von Bedeutung ist.

Alternativ ist es auch möglich, den Substratträger mit einer Oberflächenbeschichtung und/oder einer Oberflächenmodifizierung zu versehen, welche weniger Wärmestrahlung abstrahlt als ein Grundmaterial des Substratträgers. Dadurch können durch Wärmestrahlung auftretende Wärmeverluste des Substratträgers minimiert werden. Es hat sich beispielsweise als vorteilhaft herausgestellt, die Substratträgervorderseite als eine polierte Aluminiumoberfläche auszubilden, die einen Emissionsgrad relativ zu einem schwarzen Strahler bzw. einen Absorptionsgrad von kleiner als 0,2 aufweist, während die Substratträgerrückseite eine schwarz beschichtete Aluminiumoberfläche sein kann, in einem Sonderfall eine eloxierte Aluminiumoberfläche. Somit kann die Substratträgerrückseite einen Emissionsgrad bzw. einen Absorptionsgrad von deutlich über 0,5 aufweisen, besonders bevorzugt von größer als 0,9. Somit kann die Substratträgerrückseite effektiv die von der Temperiervorrichtung ausgesendete Wärmestrahlung absorbieren, während die Substratträgervorderseite möglichst wenig Wärmestrahlung emittiert.

Erfindungsgemäß ist an dem Substratträger wenigstens ein Aufnahmemodul zur Aufnahme von Laufschienen vorgesehen. Damit ist der Substratträger in der Substratbehandlungsvorrichtung entlang wenigstens einer Richtung verschieb- oder verfahrbar. Dies ermöglicht beispielsweise eine kontinuierliche Betriebsweise der Substratbehandlungsvorrichtung, indem Substratträger mit zu behandelnden oder zu bearbeitenden Substraten kontinuierlich durch eine Substratbehandlungskammer hindurch gefahren werden. Das Aufnahmemodul ist dabei außerhalb eines Substratauflagebereiches angeordnet, also an der Substratträgerrückseite und/oder an wenigstens einer Seite des Substratträgers. Weiterhin können Aufnahmemodule an unterschiedlichen Positionen vorgesehen sein, beispielsweise können Aufnahmemodule an wenigstens einem seitlichen Außenbereich des Substratträgers und/oder in einem mittigen Bereich an der Substratträgerrückseite vorgesehen sein.

Erfindungsgemäß ist das wenigstens eine Aufnahmemodul durch wenigstens ein Verbindungselement mit dem Substratträger verbunden, wobei das Verbindungselement in einer Verbindungsrichtung zwischen dem Substratträger und dem Aufnahmemodul einen geringeren Querschnitt und/oder eine größere Länge als das Aufnahmemodul aufweist. Durch die Wahl eines Verbindungsmoduls mit einem geringen Querschnitt in einer Verbindungsrichtung wird die Wärmeübertragung durch Wärmeleitung zwischen dem Substratträger und dem Aufnahmemodul geometrisch vermindert. Damit kann die Bildung einer Wärmesenke an einem Anbringungsort des wenigstens einen Aufnahmemoduls minimiert werden, was wiederum eine ungleiche Wärmeverteilung in dem Substratträger verhindert.

In der erfindungsgemäßen Substratbehandlungsvorrichtung ist das wenigstens eine Aufnahmemodul und/oder das Verbindungselement aus einem Material oder Materialverbund ausgebildet, das oder der eine geringere Wärmeleitfähigkeit als das Material des Substratträgers aufweist. Auch hierdurch wird die Wärmeübertragung zwischen dem Substratträger und dem Aufnahmemodul effektiv vermindert, was in einer möglichst gleichmäßigen Wärmeverteilung im Substratträger resultiert. Es sind also für den Substratträger und das wenigstens eine Aufnahmemodul und/oder das wenigstens eine Verbindungselement unterschiedliche Materialien vorgesehen, wodurch es bei einer Kühlung oder Heizung zu verschiedenen thermischen Ausdehnungen oder Kontraktionen des Substratträgers und des wenigstens einen Aufnahmemoduls und/oder das wenigstens einen Verbindungselementes kommen kann. Gründe hierfür sind sowohl die unterschiedlichen Temperaturen des Substratträgers, des Aufnahmemoduls und des Verbindungselementes als auch unterschiedliche thermische Ausdehnungskoeffizienten bei unterschiedlich gewählten Materialien für den Substratträger, das Aufnahmemodul und das Verbindungselement. Daher hat es sich als vorteilhaft erwiesen, das Aufnahmemodul mechanisch von dem Substratträger weitgehend zu entkoppeln. Das bedeutet, dass das oder die zwischen dem Substratträger und dem Aufnahmemodul befindliche Verbindungselement(e) die unterschiedlichen thermischen Ausdehnungen des Substratträgers,des Verbindungselementes selbst und des Aufnahmemoduls gegeneinander ausgleicht/ausgleichen. Ist das wenigtens eine Aufnahmemodul beispielsweise in Form von Laufschienen ausgebildet, kann der Substratträger von den Laufschienen mit Hilfe wenigstens eines beweglichen Verbindungselementes entkoppelt werden.

Vorteilhafte Ausführungsformen der vorliegenden Erfindung, deren Aufbau, Funktion und Vorteile sind im Folgenden anhand von Figuren näher erläutert, wobei
- Figur 1: schematisch einen Substratträger gemäß einer Ausführungsform einer erfindungsgemäßen Substratbehandlungsvorrichtung mit einem einzigen, auf der Substratträgerrückseite vorgesehenen Distanzelement in einer Draufsicht zeigt;
- Figur 2: schematisch einen Substratträger einer weiteren Ausführungsform des erfindungsgemäßen Substratträgers mit einer Vielzahl von auf der Substratträgerrückseite vorgesehenen Distanzelementen in einer Draufsicht zeigt; und
- Figur 3: schematisch eine Seitenansicht einer Ausführungsform der erfindungsgemäßen Substratbehandlungsvorrichtung mit einem Substratträger und einer Temperiervorrichtung und dazwischen angeordneten Distanzelementen zeigt.

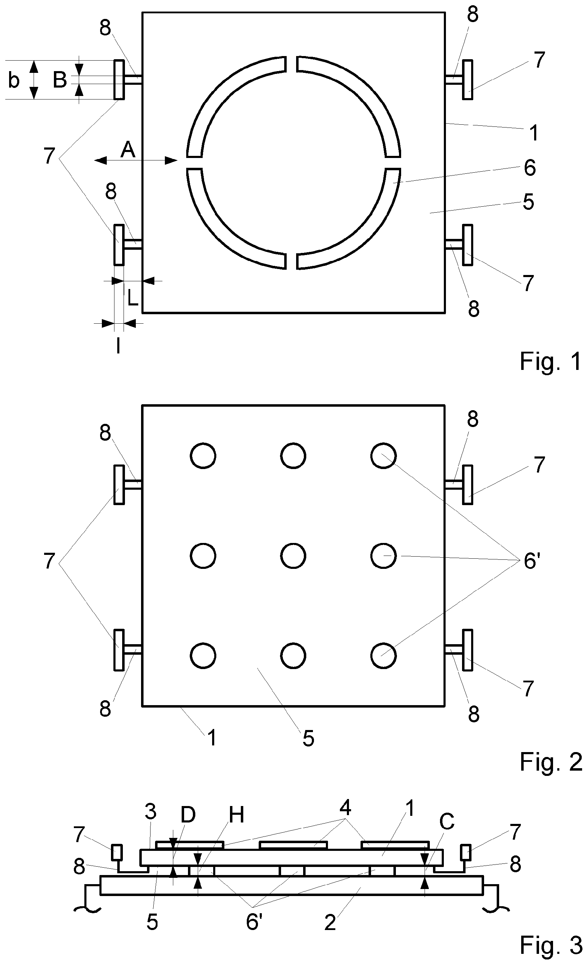

In Figur 1 ist schematisch eine Draufsicht auf eine Substratträgerrückseite 5 eines Substratträgers 1 einer Ausführungsform der erfindungsgemäßen Substratbehandlungsvorrichtung gezeigt. Gemäß dieser Ausführungsform ist auf der Substratträgerrückseite 5 genau ein Distanzelement 6 vorhanden, welches in dem gezeigten Beispiel im Querschnitt als Kreisring mit vier Unterbrechungen ausgebildet ist. Das Distanzelement 6 weist vorliegend einen Außendurchmesser auf, der etwa zwei Drittel einer Seitenlänge des Substratträgers 1 entspricht. Bevorzugterweise liegt die Differenz des Außendurchmessers und eines Innendurchmessers des Distanzelementes 6, welche die Breite des Distanzelementes 6 ergibt, in einem Bereich von 1 mm bis 30 mm, besonders bevorzugt von 10 mm bis 25 mm.

Wie in Figur 1 angedeutet, kann das Distanzelement 6 auch Ausnehmungen und/oder Unterbrechungen aufweisen. Das Distanzelement 6 kann eine andere Wärmeausdehnung aufweisen als die Temperiervorrichtung 2 oder der Substratträger 1. Durch die Unterbrechungen sowie die geringe Breite des/der Distanzelemente(s) 6 wird vermieden, dass es aufgrund der unterschiedlichen Wärmeausdehnungen zu Verformungen kommt. Ferner können anstelle des einen Distanzelementes 6 mehrere kreisring- und/oder kreisbogenförmige Distanzelemente 6 konzentrisch zueinander auf der Substratträgerrückseite 5 angeordnet sein. Somit kann/können das oder die Distanzelement(e) 6 einen gleichmäßigen Abstand C zwischen dem Substratträger 1 und einer in Figur 1 nicht dargestellten Temperiervorrichtung 2 ausbilden, wodurch eine gleichmäßige Temperaturverteilung im Substratträger 1 ermöglicht wird. Außerdem kommt es durch das oder die Distanzelement(e) zu einer verzögerten Temperierung des Substratträgers 1, die Wärmeübertragung zwischen der Temperiervorrichtung 2 und dem Substratträger 1 ist also durch das oder die Distanzelement(e) gedrosselt.

In dem in Figur 1 gezeigten Ausführungsbeispiel sind an zwei gegenüber liegenden Seiten des Substratträgers 1 je Seite zwei Aufnahmemodule 7 angeordnet, welche jeweils über ein Verbindungselement 8 mit dem Substratträger 1 verbunden sind. Alternativ ist auch die Verwendung von mehr als zwei Aufnahmemodulen 7 entlang der Länge des Substratträgers 1 möglich, um ein Durchbiegen des Substratträgers 1 zu vermeiden, beispielsweise können acht bis zehn Aufnahmemodule 7 entlang der Länge des Substratträgers 1 angeordnet werden. Die Verbindungselemente 8 weisen in der Verbindungsrichtung A zwischen Substratträger 1 und entsprechendem Aufnahmemodul 7 einen geringeren Querschnitt B als das Aufnahmemodul 7 mit dem Querschnitt b auf, können also beispielsweise stab- oder stegförmig ausgebildet sein. Zudem ist in dem gezeigten Beispiel die Länge L der Verbindungselemente 8 in der Verbindungsrichtung A größer als die Länge I der zugehörigen Aufnahmemodule 7. Durch diese Geometrie der Verbindungselemente 8 wird die Wärmeübertragung von dem Substratträger 1 auf die Aufnahmemodule 7 effektiv vermindert. In die Aufnahmemodule 7 können Laufschienen oder andere Transportmechanismen eingreifen, damit der Substratträger 1 beispielsweise durch eine Substratbearbeitungskammer bewegt werden kann.

In Figur 2 ist eine weitere Ausführungsform der erfindungsgemäßen Substratbehandlungsvorrichtung in einer Draufsicht auf die Substratträgerrückseite 5 des Substratträgers 1 gezeigt. Zur Ausbildung eines gleichmäßigen Abstandes C zwischen dem Substratträger 1 und einer in dieser Abbildung nicht dargestellten Temperiervorrichtung 2 ist eine Vielzahl der Distanzelemente 6' auf der Substratträgerrückseite 5 angeordnet. Die Distanzelemente 6' weisen hier jeweils einen kreisförmigen Querschnitt auf. Alternativ sind auch andere Querschnittsgeometrien für die Distanzelemente 6' vorstellbar, beispielsweise kreisringförmig, rechteckig, dreieckig, achteckig oder andersartig vieleckig, oval oder aber Durchbrechungen/Ausnehmungen aufweisend. Weiterhin kommen den Aufnahmemodulen 7 und den Verbindungselementen 8 die gleichen Eigenschaften und Aufgaben zu wie zu Figur 1 erläutert.

Die Ausführungsform nach Figur 2 hat gegenüber der ersten Ausführungsform gemäß Figur 1 den Vorteil, dass auch in einem Randbereich sowie in einem mittigen Bereich des Substratträgers 1 ein gleichmäßiger Abstand C zwischen dem Substratträger 1 und der Temperiervorrichtung 2 ausgebildet werden kann. Nach der Ausführungsform gemäß Figur 1 ist vorstellbar, dass sich der Substratträger 1 in den genannten, vom Distanzelement 6 entfernten Bereichen in Richtung der Temperiervorrichtung 2 durchbiegt, sodass der Abstand C zwischen der Temperiervorrichtung und dem Substratträger 1 nicht an allen Positionen gleich ist. Dies wird in der Ausführungsform gemäß Figur 2 verhindert, indem die Distanzelemente 6' gleichmäßig über die Substratträgerrückseite 5 verteilt angeordnet sind, wodurch auch in Randbereichen und dem mittigen Bereich des Substratträgers 1 ein gleichmäßiger Abstand C zu der Temperiervorrichtung 2 ausgebildet werden kann.

Alternativ zu den Ausführungsformen der Figuren 1 und 2 ist auch ohne weiteres vorstellbar und daher nicht extra zeichnerisch dargestellt, dass die Distanzelemente 6, 6' an einer dem Substratträger 1 zugewandten Seite der Temperiervorrichtung 2 angeordnet sind anstelle an der Substratträgerrückseite 5.

In Figur 3 ist eine Seitenansicht auf die zweite Ausführungsform gemäß Figur 2 gezeigt. Zwischen der Temperiervorrichtung 2 und der Substratträgerrückseite 5 des Substratträgers 1 sind gleichmäßig verteilt mehrere Distanzelemente 6' angeordnet, welche eine Höhe H aufweisen. Dadurch wird zwischen der Temperiervorrichtung 2 und dem Substratträger 1 ein gleichmäßiger Abstand C ausgebildet. Der Substratträger 1 weist eine Dicke D in einem Bereich von 8 mm bis 21 mm, bevorzugt von 10 mm bis 15 mm, besonders bevorzugt von 11 mm bis 13 mm, auf, welche zu einer ausreichenden Steifigkeit des Substratträgers 1 führt, damit dieser sich nicht verbiegt. Eine größere Dicke D des Substratträgers 1, also größer als 21 mm, ist für ein zügiges Temperieren des Substrates 4 nachteilig, da somit viel Material des Substratträgers 1 temperiert werden muss. Für bestimmte Anwendungsfälle kann eine Dicke D des Substratträgers von mehr als 21 mm auch vorteilhaft sein, da der Substratträger 1 somit eine eingestellte Temperatur auch nach abgeschalteter Temperierung länger halten kann als ein dünner Substratträger 1 mit einer Dicke D von 8 mm bis 21 mm, insbesondere bei einer Dicke D des Substratträgers 1 von weniger als 15 mm. Auch bei einem Substratträger 1 mit einer Länge und/oder Breite größer als 200 cm kann eine Dicke D des Substratträgers 1 von mehr als 21 mm vorteilhaft sein.

Auf einer Substratträgervorderseite 3 des Substratträgers 1 sind mehrere Substrate 4 angeordnet. Die Substrate 4 sollen in einem thermischen Gleichgewicht mit dem Substratträger 1 stehen, sodass die Substrate 4 indirekt durch die Temperiervorrichtung 2 geheizt und/oder gekühlt werden können. Somit können die Substrate 4 in einem Substratbehandlungsprozess auf eine gewünschte Temperatur eingestellt werden. Als Substrat(e) kann/können auf dem Substratträger 1 beispielsweise Halbleitersubstrate, etwa Siliziumwafer, aufgelegt sein.

Von der Substratträgerrückseite 5 verlaufen die Verbindungselemente 8 seitlich zu den Aufnahmemodulen 7 und verbinden diese mit dem Substratträger 1. Alternativ ist auch vorstellbar, dass die Verbindungselemente 8 an dem Substratträger 1 seitlich oder einem anderen, außerhalb eines Substratauflagebereichs des Substratträgers 1 befindlichen Bereich angeordnet sind. Die Verbindungselemente 8 weisen in der in Figur 3 gezeigten Ausführungsform zwei Umlenkungen von jeweils 90° zwischen dem Substratträger 1 und dem jeweiligen Aufnahmemodul 7 auf. Dadurch weisen die Verbindungselemente 8 eine größere Länge L auf als dies durch eine direkte Verbindung zwischen dem Substratträger 1 und dem jeweiligen Aufnahmemodul 7 entlang der Verbindungsrichtung A möglich wäre. Durch eine zunehmende Länge L der Verbindungselemente 8 wird die Wärmeleitung durch die Verbindungselemente 8 verringert, wodurch die Wärmeübertragung zwischen dem Substratträger 1 und den Aufnahmemodulen 7 minimiert wird. Dadurch wird eine Bildung von Wärmesenken in dem Substratträger 1 an den Positionen der Verbindungselemente 8 vermieden.

## Patentansprüche

1. Substratbehandlungsvorrichtung zur Behandlung von Substraten mit einem plattenförmigen Substratträger (1) und wenigstens einer plattenförmigen, parallel zu dem Substratträger (1) angeordneten Temperiervorrichtung (2), wobei der Substratträger (1) eine Substratträgervorderseite (3) zur Auflage wenigstens eines flächigen Substrates (4) und eine der Temperiervorrichtung (2) zugewandte Substratträgerrückseite (5) aufweist, wobei
an der Substratträgerrückseite (5) und/oder auf einer dem Substratträger (1) zugewandten Oberfläche der Temperiervorrichtung (2) wenigstens ein Distanzelement (6, 6') zur Ausbildung eines Abstandes (C) zwischen dem Substratträger (1) und der Temperiervorrichtung (2) vorgesehen ist,
**dadurch gekennzeichnet,**
**dass** an dem Substratträger (1) wenigstens ein Aufnahmemodul (7) zur Aufnahme von Laufschienen vorgesehen ist, wobei das Aufnahmemodul (7) an wenigstens einer Seite des Substratträgers (1) angeordnet ist;
das wenigstens eine Aufnahmemodul (7) durch wenigstens ein Verbindungselement (8) mit dem Substratträger (1) verbunden ist, wobei das Verbindungselement (8) in einer Verbindungsrichtung (A) zwischen dem Substratträger (1) und dem Aufnahmemodul (7) einen geringeren Querschnitt (B) und/oder eine größere Länge (L) als das Aufnahmemodul (7) aufweist und
das wenigstens eine Aufnahmemodul (7) und/oder das Verbindungselement (8) aus einem Material oder Materialverbund ausgebildet ist, das oder der eine geringere Wärmeleitfähigkeit als das Material des Substratträgers (1) aufweist.

2. Substratbehandlungsvorrichtung nach Anspruch 1, **dadurch gekennzeichnet, dass** eine Vielzahl der Distanzelemente (6, 6') zur Ausbildung des Abstandes (C) zwischen dem Substratträger (1) und der Temperiervorrichtung (2) vorgesehen ist.

3. Substratbehandlungsvorrichtung nach Anspruch 1 oder 2, **dadurch gekennzeichnet, dass** das Material des wenigstens einen Distanzelementes (6, 6') eine geringere Wärmeleitfähigkeit als das Material des Substratträgers (1) aufweist.

4. Substratbehandlungsvorrichtung nach wenigstens einem der vorhergehenden Ansprüche, **dadurch gekennzeichnet, dass** das wenigstens eine Distanzelement (6, 6') aus dem Substratträger (1) und/oder aus der Temperiervorrichtung (2) um eine Höhe (H) von 0,1 mm bis 1 mm auskragt.

5. Substratbehandlungsvorrichtung nach wenigstens einem der vorhergehenden Ansprüche, **dadurch gekennzeichnet, dass** das wenigstens eine Distanzelement (6, 6') eine veränderbare Höhe (H) aufweist.

6. Substratbehandlungsvorrichtung nach wenigstens einem der vorhergehenden Ansprüche, **dadurch gekennzeichnet, dass** der Substratträger (1) aus wenigstens einem elektrisch leitfähigen Material ausgebildet und/oder mit wenigstens einem elektrisch leitfähigen Material beschichtet ist.

7. Substratbehandlungsvorrichtung nach wenigstens einem der vorhergehenden Ansprüche, **dadurch gekennzeichnet, dass** der Substratträger (1) zwischen der Substratträgervorderseite (3) und der Substratträgerrückseite (5) eine Dicke (D) von 8 mm bis 21 mm aufweist.

8. Substratbehandlungsvorrichtung nach wenigstens einem der vorhergehenden Ansprüche, **dadurch gekennzeichnet, dass** die Substratträgerrückseite (5) eine Oberflächenmodifizierung und/oder eine Oberflächenbeschichtung aufweist, wobei die Oberflächenmodifizierung und/oder die Oberflächenbeschichtung mehr Wärmestrahlung absorbiert als ein Grundmaterial des Substratträgers (1).

## Claims

1. Substrate treatment device for treating substrates, comprising a planar substrate carrier (1) and at least one planar temperature control device (2) arranged in parallel with the substrate carrier (1), the substrate carrier (1) having a substrate carrier front side (3) for supporting at least one flat substrate (4) and a substrate carrier rear side (5) facing the temperature control device (2),
at least one spacer element (6, 6') for forming a distance (C) between the substrate carrier (1) and the temperature control device (2) being provided on the substrate carrier rear side (5) and/or on a surface of the temperature control device (2) facing the substrate carrier (1),
**characterized in that**
at least one receiving module (7) for receiving running rails is provided on the substrate carrier (1), the receiving module (7) being arranged on at least one side of the substrate carrier (1);
the at least one receiving module (7) is connected to the substrate carrier (1) by at least one connection element (8), the connection element (8) having a smaller cross section (B) in a direction (A) of connection between the substrate carrier (1) and the receiving module (7) and/or a greater length (L) than the receiving module (7) and
the at least one receiving module (7) and/or the connection element (8) is formed of a material or composite material which has a lower thermal conductivity than the material of the substrate carrier (1).

2. Substrate treatment device according to claim 1, **characterized in that** a plurality of the spacer elements (6, 6') is provided to form the distance (C) between the substrate carrier (1) and the temperature control device (2).

3. Substrate treatment device according to either claim 1 or claim 2, **characterized in that** the material of the at least one spacer element (6, 6') has a lower thermal conductivity than the material of the substrate carrier (1).

4. Substrate treatment device according to at least one of the preceding claims,
**characterized in that** the at least one spacer element (6, 6') projects from the substrate carrier (1) and/or from the temperature control device (2) by a height (H) of 0.1 mm to 1 mm.

5. Substrate treatment device according to at least one of the preceding claims,
**characterized in that** the at least one spacer element (6, 6') has a variable height (H).

6. Substrate treatment device according to at least one of the preceding claims,
**characterized in that** the substrate carrier (1) is formed of at least one electrically conductive material and/or is coated with at least one electrically conductive material.

7. Substrate treatment device according to at least one of the preceding claims,
**characterized in that** the substrate carrier (1) has a thickness (D) of 8 mm to 21 mm between the substrate carrier front side (3) and the substrate carrier rear side (5).

8. Substrate treatment device according to at least one of the preceding claims,
**characterized in that** the substrate carrier rear side (5) has a surface modification and/or a surface coating, the surface modification and/or the surface coating absorbing more thermal radiation than a base material of the substrate carrier (1).

## Revendications

1. Dispositif de traitement de substrat permettant de traiter des substrats, comportant un support de substrat en forme de plaque (1) et au moins un dispositif de régulation de température en forme de plaque (2) disposé parallèlement au support de substrat (1), le support de substrat (1) présentant une face avant de support de substrat (3) permettant le dépôt d'au moins un substrat plat (4) et une face arrière de support de substrat (5) faisant face au dispositif de régulation de température (2),
au moins un élément d'écartement (6, 6'), lequel permet de former une distance (C) entre le support de substrat (1) et/ou le dispositif de régulation de température (2), étant prévu sur la face arrière de support de substrat (5) et/ou sur une surface du dispositif de régulation de température (2) faisant face au support de substrat (1), **caractérisé en ce**
**qu'**au moins un module de réception (7) permettant de recevoir des rails de roulement est prévu sur le support de substrat (1), le module de réception (7) étant disposé sur au moins une face du support de substrat (1) ;
**que** l'au moins un module de réception (7) est relié au support de substrat (1) par au moins un élément de liaison (8), l'élément de liaison (8) présentant, dans une direction de liaison (A) entre le support de substrat (1) et le module de réception (7), une section transversale (B) inférieure et/ou une longueur (L) supérieure au module de réception (7) et
**que** l'au moins un module de réception (7) et/ou l'élément de liaison (8) sont formés en un matériau ou en un composite de matériau qui présente une conductivité thermique inférieure à celle du matériau du support de substrat (1).

2. Dispositif de traitement de substrat selon la revendication 1, **caractérisé en ce qu'**une pluralité des éléments d'écartement (6, 6') est prévue afin de former la distance (C) entre le support de substrat (1) et le dispositif de régulation de température (2).

3. Dispositif de traitement de substrat selon la revendication 1 ou 2, **caractérisé en ce que** le matériau de l'au moins un élément d'écartement (6, 6') présente une conductivité thermique inférieure à celle du matériau du support de substrat (1).

4. Dispositif de traitement de substrat selon au moins l'une des revendications précédentes, **caractérisé en ce que** l'au moins un élément d'écartement (6, 6') dépasse du support de substrat (1) et/ou du dispositif de régulation de température (2) d'une hauteur (H) comprise entre 0,1 mm et 1 mm.

5. Dispositif de traitement de substrat selon au moins l'une des revendications précédentes, **caractérisé en ce que** l'au moins un élément d'écartement (6, 6') présente une hauteur (H) variable.

6. Dispositif de traitement de substrat selon au moins l'une des revendications précédentes, **caractérisé en ce que** le support de substrat (1) est formé d'au moins un matériau électriquement conducteur et/ou est revêtu d'au moins un matériau électriquement conducteur.

7. Dispositif de traitement de substrat selon au moins l'une des revendications précédentes, **caractérisé en ce que** le support de substrat (1) présente une épaisseur (D) comprise entre 8 mm et 21 mm entre la face avant de support de substrat (3) et la face arrière de support de substrat (5).

8. Dispositif de traitement de substrat selon au moins l'une des revendications précédentes, **caractérisé en ce que** la face arrière de support de substrat (5) présente une modification de surface et/ou un revêtement de surface, la modification de surface et/ou le revêtement de surface absorbant plus de rayonnement thermique qu'un matériau de base du support de substrat (1).
